# EUROPÄISCHE PATENTANMELDUNG

(11) **EP 0 822 624 A1**
(43) Veröffentlichungstag der Anmeldung: **04.02.1998**
(21) Anmeldenummer: 97112961.4
(22) Anmeldetag: 28.07.1997
(51) Int. Cl.: H01R 23/70

(54) **Halteklammer zur Befestigung mindestens zweier ebener Bauteile aneinander**

(30) Priorität: 01.08.1996 DE 19631153
(71) Anmelder: SIEMENS AKTIENGESELLSCHAFT, 80333 München (DE)
(72) Erfinder: Sterckx, Rik, 8020 Oostkamp (BE); Embo, Georges, 8920 Langemark (BE)

(57) **Zusammenfassung**

Die Halteklammer (1) ist an einem in Einführrichtung hinteren Ende (8) mit einer Blattfeder (10) ausgebildet, die sich mit mindestens einem Federschenkel (18) auf der Oberfläche eines ebenen Bauteiles (25) abstützt und an der ein sich in Längsrichtung der Halteklammer erstreckender Federarm (15) mit Rastnase (16) fest angebunden ist. Der Federarm (15) ist somit zum Ausgleich von Dicken- und Bohrungstoleranzen in X- und Y-Richtung federnd angeordnet.

## Beschreibung

Die Erfindung betrifft eine Halteklammer zur Befestigung mindestens zweier ebener, plattenförmiger Bauteile aneinander, z. B. zur Befestigung eines mit einer ebenen Befestigungsfläche versehenen elektrischen Bauelements an einer Leiterplatte, bestehend aus einem einen hülsenartigen Körper bildenden Formteil mit einem in Bohrungen der ebenen Bauteile einführbaren Schaftbereich, der einen im Querschnitt offenen Ring bildet und an seinem in Einführrichtung vorderen Ende konisch und an seinem hinteren Ende mit mindestens einem die Einführbewegung begrenzenden Anschlag ausgebildet ist, und mit einem an seinem in Einführrichtung hinteren Ende fest angebundenen und an seinem vorderen Ende frei federnden Federarm, der an seinem freien Ende mit mindestens einer Rastnase versehen ist, welche nach dem Einführen der Halteklammer in die Bohrungen der ebenen Bauteile hinter einen Randbereich der Bohrung des letzten ebenen Bauteiles rastet.

Ein derartiges Befestigungselement wird anstelle von Schrauben oder Nieten zur Befestigung von elektrischen Bauelementen z. B. an einer Leiterplatte eingesetzt und ist aus der EP 0 388 478 A1 in Form eines Stiftes bekannt, der von einem einstückigen Stanzformteil gebildet ist und einen längsgeschlitzten hülsenartigen Schaftbereich mit einer Rastfeder aufweist. Die Rastfeder besitzt einen an einem Ende fest an dem Schaftbereich angebundenen ersten Federschenkel sowie einen von dem frei federnden Ende des ersten Federschenkels unter einem spitzen Winkel zurückgebogenen zweiten Federschenkel mit einem zum ersten Federschenkel hin umgebogenen Endstück, dessen Außenseite einen Rastbereich bildet, der hinter einen der Einschubseite des Stiftes abgewandten Randbereich der Bohrung des betreffenden Bauteiles einrastet. Ferner ist der Stift an seinem in Einschubrichtung hinteren Ende noch mit einem seine Einschubbewegung begrenzenden Anschlag versehen, der von zwei an der hinteren Stirnfläche des Schaftbereiches nach außen abgebogenen und einander gegenüberliegenden Kontaktlappen gebildet ist. Der bekannte Stift soll ohne aktives Entriegeln nicht wieder herausziehbar sein und Toleranzen in der Dicke der einzelnen Bauteile und in den Bohrungsdurchmessern ausgleichen können.

Der Erfindung liegt die Aufgabe zugrunde, eine Halteklammer der eingangs genannten Art so auszubilden, daß einerseits ein zuverlässiger Ausgleich der Toleranzen in der Dicke der einzelnen Bauteile und in den Bohrungsdurchmessern und andererseits aber auch eine rüttelfreie und ortsfeste Verbindung gewährleistet wird.

Diese Aufgabe wird bei einer Halteklammer der eingangs genannten Art gemäß der Erfindung durch folgende Merkmale gelöst:
a)an dem in Einführrichtung hinteren Ende des Schaftbereiches der Halteklammer ist eine Blattfeder fest angebunden, die von dem Schaftbereich abragt und diesen mit einem brückenartig geformten Bereich überspannt`
b)die Blattfeder ist mit mindestens einem sich an den brückenartigen Bereich anschließenden, länglichen frei federnden Federschenkel ausgebildet, der im in die Bohrungen der ebenen Bauteile eingeführten Zustand der Halteklammer im Bereich seines Endes auf der Oberfläche des entsprechenden Bauteiles federnd aufliegt,
c)der an seinem frei federnden Ende mit der Rastnase versehene Federarm ist zwischen dem fest angebundenen Ende und dem frei federnden Federschenkel der Blattfeder fest an dieser angebunden.

Bei einer derartigen Halteklammer ist der Federarm an einer Blattfeder fest angebunden, welche an dem in Einführrichtung hinteren Ende des Schaftbereiches der Halteklammer an einem Ende fest an dem Schaftbereich angebunden und ansonsten frei federnd ist. Auf diese Weise ist der Federarm sowohl in X-Richtung quer zur Längsrichtung der Halteklammer als auch in Y-Richtung, d. h. in Richtung der Längsrichtung der Halteklammer, federnd aufgehängt. Dadurch ist es möglich, mit einem derart federnd angeordneten Federarm Toleranzen in der Dicke der einzelnen Bauteile und in den Bohrungsdurchmessern in zuverlässiger Weise auszugleichen. Dieser doppelte Toleranzausgleich wird durch den sich in Längsrichtung der Halteklammer erstreckenden Federarm, seine Anbindung an einer stirnseitigen Blattfeder und deren Auflage auf der Oberfläche des entsprechenden Bauteiles erreicht, so daß die Rastnase des Federarmes nicht selbst in den Toleranzausgleich integriert ist und damit starr ausgebildet werden kann. Es ist damit zugleich eine der Forderung nach doppeltem Toleranzausgleich eher der entgegenstehende, rüttelfreie und ortsfeste Verbindung erreichbar. Ein weiterer Vorteil der erfindungsgemäßen Halteklammer besteht darin, daß bei manueller Montage der Halteklammer lediglich eine leichte vertikale Kraft F auf den brückenartigen Bereich der Blattfeder ausgeübt zu werden braucht, um die Halteklammer in die Bohrungen der ebenen, aneinander zu befestigenden Bauteile eindrücken zu können. Dabei schnappt die starre Rastnase hinter einen Randbereich der Bohrung des letzten ebenen Bauteiles, also z. B. hinter die Unterseite eines Leiterplattenloches, wobei die Halteklammer durch die Blattfederwirkung unter Kraft weiter in X- und Y-Richtung angezogen und eine sichere Verbindung erreicht wird. Dies ist insbesondere auch dann von Vorteil, wenn nach der Befestigung der Halteklammer eine starre Verbindung zum Beispiel mit einer Leiterplatte durch Löten geschaffen werden soll, weil bei eventuellen Stoßeinwirkungen quer zur Längsrichtung der Halteklammer diese immer wieder in die ursprüngliche Position zurückgezogen wird. Schließlich ergibt sich durch den länglichen, auf der Oberfläche des entsprechenden Bauteiles aufliegenden Federschenkel der Blattfeder noch ein sich auf diesem Bauteil abstützender Hebelarm, der in vorteilhafter Weise an der Verbindung angreifenden Kippmomenten entgegenwirkt.

Im Hinblick auf die Wirkung des Federschenkels der Blattfeder als Hebelarm ist es vorteilhaft, wenn die Länge des Federschenkels der Blattfeder etwa der Länge des brückenartigen Bereiches entspricht.

Die Montage der Halteklammer, insbesondere eine manuelle Montage, wird in vorteilhafter Weise dadurch erleichtert, daß der Schaftbereich der Halteklammer mit einer im Querschnitt etwa C-förmigen Zentrierzone und an dem in Einführrichtung vorderen Ende mit einer konischen Vorzentrierzone ausgebildet ist. Durch die Vorzentrierzone wird das 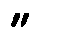 Suchen" der Bohrungen, in welche die Halteklammer eingesteckt werden soll, erleichtert, während die im Querschnitt etwa C-förmige Zentrierzone einen Paßsitz in den Bohrungen bewirkt.

Ferner ist es vorteilhaft, wenn der die Einführbewegung begrenzende Anschlag in seiner Erstreckung in Längsrichtung der Halteklammer so angeordnet und ausgebildet ist, daß er gleichzeitig als Schutz der Blattfeder gegen überdehnung dient.

Die erfindungsgemäße Halteklammer kann aus Kunststoff oder Metall bestehen. Besonders zweckmäßig ist es, wenn die Halteklammer aus einem metallenen Stanz-Biegeteil besteht. Halteklammern aus Metall weisen eine bessere Funktion auf, weil sie eine größere Belastbarkeit und Lebensdauer haben und eine bessere Federwirkung erreichbar ist. Außerdem kann durch Löten noch eine zusätzliche, starre mechanische Befestigung geschaffen werden. Schließlich ist es möglich, bei Bedarf über eine metallene Halteklammer eine elektrische Massekontaktierung mit einer Leiterplatte herzustellen.

Weitere vorteilhafte Ausgestaltungen des Gegenstandes des Patentanspruches 1 sind in den übrigen Unteransprüchen angegeben.

Die Erfindung und weitere Einzelheiten einer erfindungsgemäßen Halteklammer werden im folgenden anhand der Zeichnung näher beschrieben. Es zeigen die
Figuren 1, 2 und 3 eine Halteklammer in Seitenansicht, Vorderansicht und Draufsicht,
Figur 4 eine Abwicklung der Halteklammer,
Figur 5 die Herstellung einer Verbindung zweier ebener plattenförmiger Bauteile aneinander, wobei die Halteklammer bereits in eine Bohrung eines ersten Bauteiles eingesteckt ist und
Figur 6 die Befestigung der beiden Bauteile aneinander im Zustand der Endmontage.

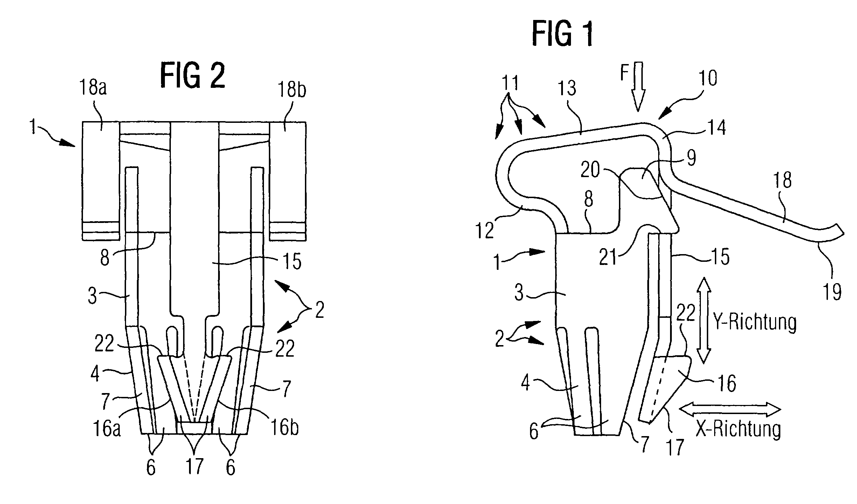

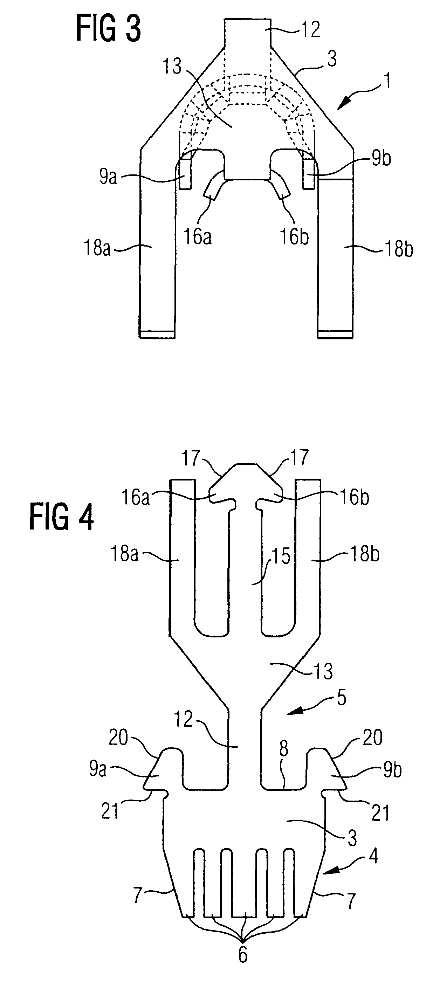

Die Halteklammer 1 dient zur Befestigung mindestens zweier ebener, plattenförmiger Bauteile 25, 26 aneinander und besteht aus einem einen hülsenartigen Körper bildenden Formteil aus Kunststoff oder Metall, das einen Schaftbereich 2 aufweist, welcher als im Querschnitt offener Ring ausgebildet ist. Der Schaftbereich 2 hat eine im Querschnitt etwa C-förmige Zentrierzone 3, die an ihrem in Einführrichtung der Halteklammer vorderen Ende mit einer konischen Vorzentrierzone 4 fortgesetzt ist, welche zum leichteren Auffinden von Bohrungen der Bauteile, in welche die Halteklammer eingesteckt werden soll, dient. Hierzu ist die Vorzentrierzone 4 bei der dargestellten Ausführungsform der Halteklammer - wie die Figur 4 zeigt - von in der Abwicklung 5 der Halteklammer zueinander parallelen und voneinander beabstandeten streifenförmigen Zungen 6 gebildet, wobei die beiden äußersten Zungen 6 eine in Einführrichtung der Halteklammer konvergierende äußere Schräge 7 aufweisen. An seinem in Einführrichtung hinteren Ende 8 ist der Schaftbereich 2 mit mindestens einem die Einführbewegung begrenzenden Anschlag 9 ausgebildet, dessen Anordnung und Gestaltung später noch genauer erläutert wird. Außerdem ist an dem in Einführrichtung hinteren Ende 8 des Schaftbereiches 2 eine Blattfeder 10 vorgesehen, welche vom Schaftbereich abragt und diesen mit einem brückenartig geformten Bereich 11 überspannt. Hierzu ist die Blattfeder 10 am hinteren Ende 8 des Schaftbereiches 2 zunächst mit einer etwa S-förmig gebogenen Anbindung 12 seitlich vom dem Schaftbereich weggeführt. Anschließend an diese Anbindung 12 ist die Blattfeder 10 mit einem etwa horizontal verlaufenden Mittelstück 13 zurückgebogen, das hier an seinem Ende 14 in drei Federteilelemente aufgeteilt ist, nämlich in einen in der Abwicklung zentralen, an seinem in Einführrichtung hinteren Ende fest angebundenen und am anderen vorderen Ende frei federnden Federarm 15 und in zwei in der Abwicklung des Formteiles in seitlichem Abstand symmetrisch zu dem zentralen Federarm 15 angeordneten Federschenkelteile 18a und 18b. Der Federarm 15 ist streifenförmig ausgebildet, erstreckt sich zunächst gerade von dem Mittelstück 13 ausgehend in Richtung der Längsachse der Halteklammer 1 und ist an seinem freien Ende etwa parallel zu der äußeren Schräge 7 der äußersten Zungen 6 der Vorzentrierzone 4 verlaufend abgebogen und an diesem Ende mit mindestens einer Rastnase 16 versehen. Dabei ist diese Rastnase 16 - wie insbesondere die Figuren 2 und 3 deutlich zeigen - von zwei seitlich an dem Federarm 15 angeordneten, schräg abgewinkelten starren Flügeln 16a und 16b gebildet, die mit einer in Enführrichtung konvergierenden äußeren Schräge 17 versehen sind. An der der Unterseite des letzten ebenen Bauteiles 26 zugewandten Seite sind die Flügel 16a und 16b mit einer Oberkante 22 ausgebildet, welche etwa parallel zu der Unterseite des Bauteiles 26, vorzugsweise unter einem kleinen spitzen Winkel hierzu, verläuft.

Die beiden streifenförmigen Federschenkelteile 18a und 18b sind von dem Mittelstück 13 der Blattfeder 10 zunächst etwa rechtwinkelig und dann hiervon mit einem Winkel > 90° abgebogen, etwa so lang wie der brückenartige Bereich 11 der Blattfeder 10 und an ihrem Ende nach einem Scheitel 19 wieder etwas von dem Bauteil 25, in dessen Bohrung 27 die Halteklammer zunächst eingesteckt wird, aufgebogen.

Nachfolgend ist nun die Anordnung und Ausbildung des die Einführbewegung der Halteklammer 1 begrenzenden Anschlages 9 genauer beschrieben. Der Anschlag 9 ist von zwei Laschen 9a, 9b gebildet, die bei dem Formteil in Figur 1 der Anbindung 12 der Blattfeder 10 gegenüberliegend und in der Abwicklung 5 nach Figur 4 seitlich und symmetrisch zu der Anbindung 12 angeordnet sind. Die Laschen 9a und 9b liegen in der Abwicklung 5 nach Figur 4 in der Ebene der Abwicklung, d. h. sie stehen später senkrecht zu den miteinander zu verbindenden Bauteilen 25, 26. Die Höhe der Laschen 9a, 9b ist auf den Federweg der Blattfeder abgestimmt, d. h. die Laschen sind in ihrer Erstreckung der Längsrichtung der Halteklammer so angeordnet und ausgebildet, daß sie gleichzeitig als Schutz der Blattfeder 10 gegen Überdehnung bei zu starker manueller Bedienung der Blattfeder wirken. Außerdem sind die Laschen 9a, 9b an der den Federschenkelteilen 18a, 18b der Blattfeder 10 zugewandten Seite mit einer in Einführrichtung divergierenden Schräge 20 sowie an der der Oberfläche des entsprechenden ebenen Bauteiles 25 zugewandten Unterseite mit einer quer, vorzugsweise senkrecht zur Längsachse der Halteklammer verlaufenden Abstützkante 21 versehen.

Das dargestellte Formteil ist in seiner Abwicklung 5 symmetrisch in bezug auf eine in Längsrichtung der Halteklammer 1 verlaufende Mittelachse der Abwicklung ausgebildet und zweckmäßigerweise aus einem metallenen Stanz-Biegeteil hergestellt, welches zu der in den Figuren 1 bis 3 gezeigten Halteklammer gebogen ist.

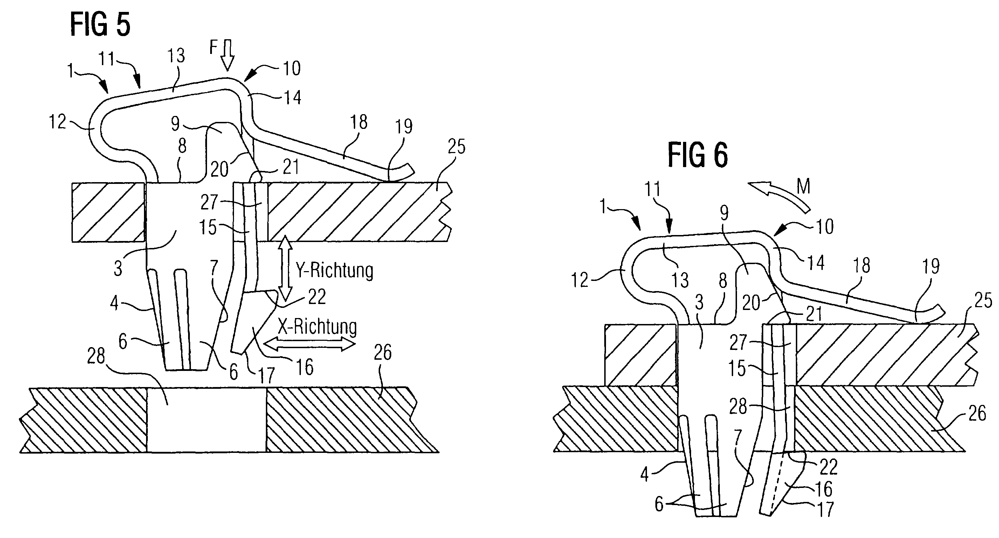

Anhand der Figuren 5 und 6 wird abschließend die mittels der Halteklammer 1 durchzuführende Befestigung zweier ebener, plattenförmiger Bauteile 25 und 26 aneinander beschrieben. Hierbei kann es sich z. B. um die Befestigung eines Stecker- und/oder Buchsenelemente aufweisenden, bekannten und deshalb hier nicht dargestellten elektrischen Steckverbinders an einer Leiterplatte handeln, wobei das z. B. um 90° zur Steckseite des Steckverbinders abgewinkelte ebene Bauteil 25, z. B. ein Befestigungswinkel oder - flansch des Steckverbinders, mit Hilfe der Halteklammer 1 an einer Unterlage, z. B. an einer Leiterplatte 26 befestigt wird. Hierzu ist die Halteklammer 1 in die als Befestigungslöcher dienenden Bohrungen 27 und 28, die toleranzbedingt unterschiedliche Durchmesser aufweisen können, einzustecken. Bei der manuell durchzuführenden Montage des Steckverbinders an der Leiterplatte sucht zunächst die Vorzentrierzone 4 der bereits in die Bohrung 27 des Bauteiles 25 eingesetzten Halteklammer 1 (Figur 5) zusammen mit der äußeren Schräge 17 der Rastnase 16 die Bohrung 28 der Leiterplatte 26 zu erfassen. Anschließend wird eine leichte vertikale Kraft F manuell auf das Mittelstück 13 der Blattfeder 10 ausgeubt und die Halteklammer 1 in die Bohrung 28 der Leiterplatte 26 eingedrückt. Hierdurch schnappt die Rastnase 16 des in X- und Y-Richtung federnden Federarmes 15 der Halteklammer 1 hinter die Unterseite der Leiterplattenbohrung 27, wobei die Halteklammer im eingeführten Zustand durch die Blattfeder 10 in X- und Y-Richtung angezogen wird. Somit werden Toleranzen in der Dicke der Bauteile 25 und 26 sowie in den Durchmessern der Bohrungen 27 und 28 eliminiert. Außerdem wird zwischen dem die Einschubbewegung begrenzenden Anschlag 9 und der starren Rastnase 16 des Federarmes 15 eine rüttelfreie und ortsfeste Verbindung erreicht. Durch Löten kann eine starre, unlösbare Verbindung geschaffen werden, wobei die Vorzentrierzone 4 und die Zentrierzone 2 der Halteklammer 1 mit Lötmittel vollfließen. Auf diese Weise kann auch eine elektrische Massekontaktierung des elektrischen Bauteiles 25 und damit eines Steckverbinders an einer Leiterplatte oder einem Chassis hergestellt werden.

Die in Figur 6 dargestellte Verbindung eignet sich vorteilhaft für die Befestigung eines mit einem Befestigungsflansch um 90° zur Steckseite abgewinkelten elektrischen Steckverbinders an einer Leiterplatte, wobei es neben dem doppelten Toleranzausgleich infolge der Anbindung des Federarmes 15 der Halteklammer 1 an deren Blattfeder 10, dem Zusammenwirken der Blattfeder 10 und des Federarmes 15 und der damit erreichten Federung des Federarmes 15 in X- und Y-Richtung von zusätzlichem Vorteil ist, daß der Federschenkel 18 bzw. die Federschenkelteile 18a und 18b der Blattfeder 10 bei einem Kippmoment M, welches z. B. beim Anstoßen in Steckrichtung des Steckverbinders ausgelöst werden kann, diesem Kippmoment entgegenwirken und die Halteklammer immer in die richtige ursprüngliche Befestigungsposition drücken. Außerdem wirkt bei einem derartigen Vorgang wie auch bei einem Versuch, die Halteklammer ohne aktives Lösen der Verrastung herausziehen zu wollen, die starre Rastnase 16 des Federarmes 15 einer Lösung der Halteklammer aus ihrer verrasteten Endposition unnachgiebig und widerhakenartig entgegen.

## Patentansprüche

1. Halteklammer (1) zur Befestigung mindestens zweier ebener, plattenförmiger Bauteile (25, 26) aneinander, z. B. zur Befestigung eines mit einer ebenen Befestigungsfläche versehenen elektrischen Bauelementes an einer Leiterplatte, bestehend aus einem einen hülsenartigen Körper bildenden Formteil mit einem in Bohrungen (27, 28)der ebenen Bauteile (25, 26) einführbaren Schaftbereich (2), der einen im Querschnitt offenen Ring bildet und an seinem in Einführrichtung vorderen Ende konisch und an seinem hinteren Ende (8) mit mindestes einem die Einführbewegung begrenzenden Anschlag (9) ausgebildet ist, und mit einem an seinem in Einführrichtung hinteren Ende (8) fest angebundenen und an seinem vorderen Ende frei federnden Federarm (15), der an seinem freien Ende mit mindestens einer Rastnase (16) versehen ist, welche nach dem Einführen der Halteklammer (1) in die Bohrungen (27, 28) der ebenen Bauteile (25, 26) hinter einen Randbereich der Bohrung (28) des letzten ebenen Bauteiles (26) rastet,
**gekennzeichnet durch** folgende Merkmale:
a)an dem in Einführrichtung hinteren Ende (8) des Schaftbereiches (2) der Halteklammer (1) ist eine Blattfeder (10) fest angebunden, die von dem Schaftbereich (2) abragt und diesen mit einem brückenartig geformten Bereich (11) überspannt,
b)die Blattfeder (10) ist mit mindestens einem sich an den brückenartigen Bereich (11) anschließenden, länglichen frei federnden Federschenkel (18) ausgebildet, der im in die Bohrungen (27, 28) der ebenen Bauteile (25, 26) eingeführten Zustand der Halteklammer (1) im Bereich seines Endes auf der Oberfläche des entsprechenden Bauteiles (25) federnd aufliegt,
c) der an seinem frei federnden Ende mit der Rastnase (16) versehene Federarm (15) ist zwischen dem fest angebundenen Ende und dem frei federnden Federschenkel (18) der Blattfeder (10) fest an dieser angebunden.

2. Halteklammer nach Anspruch 1, **dadurch gekennzeichnet**, daß die Blattfeder (10) am hinteren Ende (8) des Schaftbereiches (2) zunächst mit einer etwa S-förmig gebogenen Anbindung (12) seitlich von dem Schaftbereich (2) weggeführt und dann anschließend mit einem etwa horizontal verlaufenden Mittelstück (13) zurückgebogen ist, daß von dem Mittelstück (13) zwei Federschenkelteile (18a, 18b) abgebogen und in der Abwicklung (5) des Formteiles in seitlichem Abstand symmetrisch zu dem am Mittelstück (13) fest angebundenen Federarm (15) angeordnet sind.

3. Halteklammer nach Anspruch 1 oder 2, **dadurch gekennzeichnet**, daß jeder Federschenkelteil (18a, 18b) der Blattfeder (10) an seinem Ende nach einem auf der Oberfläche des entsprechenden Bauteiles (25) aufliegenden Scheitel (19) von diesem und dem Bauteil (25) weg abgebogen ist.

4. Halteklammer nach einem der Ansprüche 1 bis 3, **dadurch gekennzeichnet**, daß die Länge des Federschenkels (18) der Blattfeder (10) etwa der Länge des brückenartigen Bereiches (11) entspricht.

5. Halteklammer nach einem der vorhergehenden Ansprüche, **dadurch gekennzeichnet**, daß sich der Federarm (15) der Halteklammer (1) von dem Mittelstück (13) der Blattfeder (10) in Richtung der Längsachse der Halteklammer (1) erstreckt und an seinem mit der Rastnase (16) versehenen Ende etwa parallel zu dem konischen Ende des Schaftbereiches (2) verlaufend abgebogen ist.

6. Halteklammer nach einem der vorhergehenden Ansprüche, **dadurch gekennzeichnet**, daß die Rastnase (16) des Federarmes (15) von zwei seitlich an dem Federarm angeordneten, abgewinkelten starren Flügeln (16a, 16b) gebildet ist, die mit einer in Einführrichtung konvergierenden äußeren Schräge (17) und an der der Unterseite des letzten ebenen Bauteiles (26) zugewandten Seite mit einer hierzu etwa parallelen Oberkante (22) ausgebildet sind.

7. Halteklammer nach einem der Ansprüche 2 bis 6, **dadurch gekennzeichnet**, daß der Federarm (15) sowie die Federschenkelteile (18a, 18b) und die Anbindung (12) der Blattfeder (10) streifenförmig ausgebildet sind.

8. Halteklammer nach einem der vorhergehenden Ansprüche, **dadurch gekennzeichnet**, daß der Schaftbereich (2) der Halteklammer (1) mit einer im Querschnitt etwa C-förmigen Zentrierzone (3) und an dem in Einführrichtung vorderen Ende mit einer konischen Vorzentrierzone (4) ausgebildet ist.

9. Halteklammer nach Anspruch 8, **dadurch gekennzeichnet**, daß die Vorzentrierzone (4) von in der Abwicklung (5) des Formteiles zueinander parallelen und voneinander beabstandeten streifenförmigen Zungen (6) gebildet ist und die äußersten Zungen (6) eine in Einführrichtung konvergierende äußere Schräge (7) aufweisen.

10. Halteklammer nach einem der vorhergehenden Ansprüche, **dadurch gekennzeichnet**, daß der die Einführbewegung begrenzende Anschlag (9) in seiner Erstreckung in Längsrichtung der Halteklammer (1) so angeordnet und ausgebildet ist, daß er gleichzeitig als Schutz der Blattfeder (10) gegen Überdehnung dient.

11. Halteklammer nach einem der vorhergehenden Ansprüche, **dadurch gekennzeichnet**, daß der die Einführbewegung begrenzende Anschlag (9) von zwei Laschen (9a, 9b) gebildet ist, die an dem in Einführrichtung hinteren Ende (8) des Schaftbereiches (2) in der Abwicklung (5) des Formteiles symmetrisch zu der Anbindung (12) der Blattfeder (10) angeordnet sind.

12. Halteklammer nach Anspruch 11, **dadurch gekennzeichnet**, daß die Laschen (9a, 9b) senkrecht zu den ebenen Bauteilen (25, 26) stehen und an der den Federschenkelteilen (18a, 18b) der Blattfeder (10) zugewandten Seite mit einer in Einführrichtung divergierenden Schräge (20) sowie an der der Oberfläche des entsprechenden ebenen Bauteiles (25) zugewandten Unterseite mit einer quer, vorzugsweise senkrecht zur Längsachse der Halteklammer (1) verlaufenden Abstützkante (21) versehen sind.

13. Halteklammer nach Anspruch 11 oder 12, **dadurch gekennzeichnet**, daß die Höhe der Laschen (9a, 9b) auf den Federweg der Federschenkelteile (18a, 18b) der Blattfeder (10) abgestimmt ist.

14. Halteklammer nach einem der Ansprüche 11 bis 13, **dadurch gekennzeichnet**, daß die Laschen (9a, 9b) der Anbindung (12) der Blattfeder (10) der Halteklammer (1) gegenüberliegend angeordnet sind.

15. Halteklammer nach einem der vorhergehenden Ansprüche, **dadurch gekennzeichnet,** daß das gesamte Formteil in seiner Abwicklung (5) symmetrisch in bezug auf eine in Längsrichtung der Halteklammer (1) verlaufende Mittelachse der Abwicklung (5) ausgebildet ist.

16. Halteklammer nach einem der vorhergehenden Ansprüche, **dadurch gekennzeichnet**, daß die Halteklammer (1) aus einem metallenen Stanz-Biegeteil besteht.
